# EUROPÄISCHE PATENTSCHRIFT

(11) **EP 0 892 992 B1**
(45) Veröffentlichungstag und Bekanntmachung des Hinweises auf die Patenterteilung: **28.01.2004**
(21) Anmeldenummer: 97922827.7
(22) Anmeldetag: 07.04.1997
(51) Int. Cl.: H01L 31/105, H01L 25/04, H01L 27/14

(54) **DREI-FARBENSENSOR MIT EINER PIN- ODER NIP-SCHICHTENFOLGE**
THREE-COLOUR SENSOR WITH A PIN OR NIP SERIES OF LAYERS
CAPTEUR TRICHROME AVEC UNE SERIE DE COUCHES PIN OU NIP

(30) Priorität: 09.04.1996 DE 19613820
(43) Veröffentlichungstag der Anmeldung: 27.01.1999
(73) Patentinhaber: Forschungszentrum Jülich GmbH, 52425 Jülich (DE)
(72) Erfinder: STIEBIG, Helmut, D-52428 Jülich (DE); FÖLSCH, Joachim, D-63755 Alzenau (DE); KNIPP, Dietmar, D-52064 Aachen (DE)
(86) Internationale Anmeldenummer: PCT/DE1997/000713
(87) Internationale Veröffentlichungsnummer: WO 1997/038450

(56) Entgegenhaltungen:
- EP-A- 0 682 375
- WO-A-96/13865
- STIEBIG H ET AL: "Amorphous silicon three color detector" AMORPHOUS SILICON TECHNOLOGY - 1995. SYMPOSIUM, AMORPHOUS SILICON TECHNOLOGY - 1995. SYMPOSIUM, SAN FRANCISCO, CA, USA, 18-21 APRIL 1995, 1995, PITTSBURGH, PA, USA, MATER. RES. SOC, USA, Seiten 815-826, XP002039540 in der Anmeldung erwähnt
- TSAI H -K ET AL: "AMORPHOUS SIC/SI THREE-COLOR DETECTOR" APPLIED PHYSICS LETTERS, Bd. 52, Nr. 4, 25.Januar 1988, Seiten 275-277, XP002022892
- GIAMPERO DE CESARE ET AL: "TUNABLE PHOTODETECTORS BASED ON AMORPHOUS SI/SIC HETEROSTRUCTURES" IEEE TRANSACTIONS ON ELECTRON DEVICES, Bd. 42, Nr. 5, 1.Mai 1995, Seiten 835-840, XP000500493

## Beschreibung

Die Erfindung betrifft eine Struktur mit mehreren i-Schichten, die an einer Seite von einer p-Schicht an der anderen Seite von einer n-Schicht begrenzt wird, gemäß dem Oberbegriff des Anspruchs 1. Desweiteren betrifft die Erfindung ein eine solche Struktur enthaltendes Bauelement, insbesondere einen Mehrfarbensensor auf der Basis einer pin- oder nip-Struktur, gemäß dem Oberbegriff des Anspruchs 10. Desweiteren betrifft die Erfindung ein Verfahren zur Herstellung einer solchen Struktur gemäß dem Oberbegriff des Anspruchs 11.

Als Stand der Technik bekannt sind Bauelemente auf der Basis von amorphem Silizium oder dessen Legierungen, bestehend aus zwei antiseriell angeordneten pin- oder nip-Dioden zur Bildung einer pinip- oder nipin-Struktur. Die Dioden sind hierbei im wesentlichen vertikal zur Lichteinfallsrichtung angeordnet.

Eine solche nipin-Struktur als photoempfindliches elektronisches Bauelement auf der Basis von amorphem Silizium ist zum Beispiel aus US-Patent 53 11 047 bekannt.

Zur Optimierung einer solchen nipin-Struktur in Bezug auf die von der an diese Struktur angelegten Spannung abhängige spektrale Empfindlichkeit ist zudem bekannt:

Durch Einbau zusätzlicher, eigenleitender Schichten auf beiden Seiten der p-dotierten Schicht mit einem Bandabstand zwischen 1,74 eV und 1,9 eV kann die Blau/Grün-Empfindlichkeit in der in Lichteinfallsrichtung vorgeordneten nip-Struktur bzw. die Rot/Grün-Trennung in der in Lichteinfallsrichtung nachgeordneten pin-Struktur verbessert werden. (Q. Zhu, H. Stiebig, P. Rieve, J. Giehl, M. Sommer, M. Böhm, "NEW TYPE OF THIN FILM IMAGE SENSOR" in Sensors and Control for Advanced Automation, edited by M. Becker, R. W. Daniel, O. Loffeld, Proc. SPIE 2247 (1994) 301).

Es ist bekannt, vorzugsweise in der ersten eigenleitenden Schicht blaues Licht, im vorderen Teil der eigenleitenden Schicht der hinteren Diode grünes Licht und durch Reduktion des µτ-Produkts im hinteren Teil der zweiten eigenleitenden Schicht rotes Licht zu absorbieren. Dazu wird eine nipin-Struktur verwendet, bei der eine oder mehrere zusätzliche i-Schichten vorgesehen sind. (H. Stiebig, J. Giehl, D. Knipp, P. Rieve, M. Böhm, AMORHOUS SILICON THREE COLOR DETECTOR in MRS Symp. Proc. 377 (1995) 813 oder H. Stiebig, C. Ulrichs, T. Kulessa, J. Fölsch, F. Finger, H. Wagner, TRANSIENT PHOTOCURRENT RESPONSE OF A-SI:H BASED THREE COLOR NIPIN DETECTORS, in ICAS 16, Kobe, Japan, September, 4 - 8, 1995).Dabei ist τ die Lebensdauer der durch das einfallende Licht generierten Ladungsträger und µ deren Beweglichkeit.

Aus Tsai et al. (Amorphous SiC/Si three-colour detector. Applied physics letters, Bd. 52, Nr 4, 25. Januar 1988, Seiten 275-277) ist eine nipiin-Schicht bekannt. Die beiden benachbarten i-Schichten sind so hergestellt, daß die Bandlücke der Lichteintrittsseite näher liegenden i-Schicht eine größere Bandlücke aufweist als die der Lichteintrittsseite weiter entfernten i-Schicht.

Aus WO 96/13865 ist eine Struktur bekannt, bei welcher eine verbesserte spektrale Selektivität erzielt wird, indem das Produkt µτ in der in Lichteinfallsrichtung vorgeordneten Teilschicht I höher ist als das in der in Lichteinfallsrichtung nachgeordneten Teilschicht II.

Nachteilig bei den bekannten, genannten Bauelementen werden durch den Aufbau des Schichtsystem lediglich bis zu drei linear unabhängige, spektrale Empfindlichkeitsverläufe detektiert. Folglich ist eine vergleichsweise aufwendige Superposition dieser drei unabhängigen Signale zur farblichen Bildverarbeitung erforderlich. Weiterhin sind vergleichsweise aufwendige, antiseriell zueinander geschaltete Strukturen zur Realisierung des Sensors nötig.

Der Erfindung liegt-deshalb die Aufgabe zugrunde, eine Struktur mit mehreren i-Schichten zu schaffen, bei der unabhängige Signale derart erhalten werden, daß eine verringerte Superposition erforderlich ist, bis hin zur Vermeidung einer solchen Superposition.

Desweiteren ist es Aufgabe der Erfindung ein kostengünstiges optoelektronisches Bauelement, insbesondere einen Mehrfarbensensor, zu schaffen, welches dazu geeignet ist, seine spektrale Empfindlichkeit durch Variation der angelegten Spannung kontinuierlich zu verschieben und damit eine erwünschte Randbedingungen erfüllende, spektrale Empfindlichkeit zu erhalten, um insbesondere damit mehr als drei linear unabhängige Verläufe der spektralen Empfindlichkeit im Bereich vom UV bis zum nahen IR einfallendes Licht zu detektieren und dabei eine Verringerung der Superpositionserfordernisse zu erreichen.

Die Aufgabe wird gelöst durch eine Struktur gemäß der Gesamtheit der Merkmale nach Anspruch 1. Die Aufgabe wird ferner gelöst durch ein Bauelement gemäß der Gesamtheit der Merkmale nach Anspruch 10. Die Aufgabe wird ferner gelöst durch ein Verfahren gemäß der Gesamtheit der Merkmale nach Anspruch 11. Weitere zweckmäßige oder vorteilhafte Ausführungsformen oder Varianten finden sich in den auf jeweils einen dieser Ansprüche rückbezogenen Unteransprüchen.

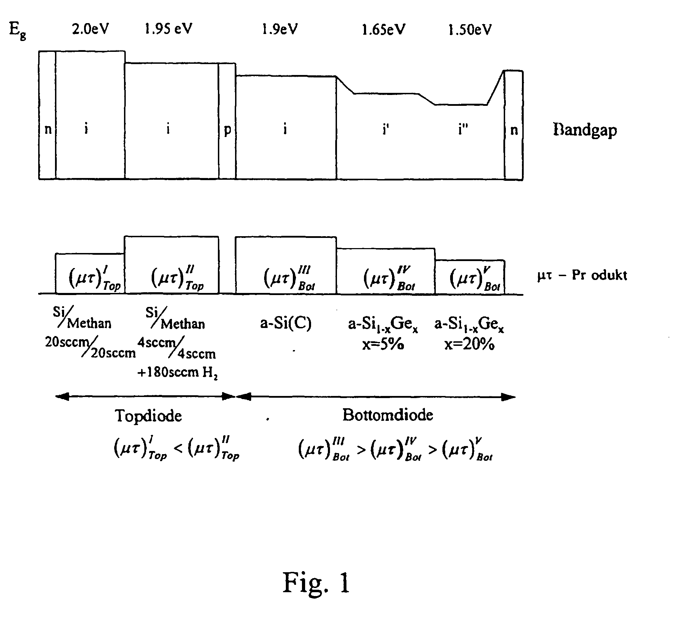

Es wurde erkannt, daß zur Erweiterung der Funktionsfähigkeit eines, eine solche Struktur enthaltenden Bauelements, von der Lichteinfallsrichtung aus in der Regel die jeweilige Bandlücke E_{g} wenigstens dreier benachbarter i-Schichten durch geeignete Wahl der Legierungen abnimmt, während die Transporteigenschaften (die mit Hilfe des Produkts µτ charakterisiert werden können) der photogenerierten Ladungsträger für eine nipin-Struktur in beiden intrinsischen Schichtensystemen der Top- und Bottomdiode in Richtung der p-Schicht besser werden (siehe Figur 1). Für eine pinip-Struktur wird wie bei der nipin-Struktur in der Regel die Bandlücke der einzelnen Schichten durch geeignete Wahl der Legierungen von der Lichteinfallsrichtung aus reduziert, während das µτ-Produkt von der n-leitenden Schicht zu beiden p-leitenden Schichten ansteigt.

Mit der Formulierung "in der Regel" im obigen Sinne ist gemeint, daß erkannt wurde, daß zumindest im Grenzbereich zweier benachbarter i-Schichten die im Hauptanspruch formulierte Bedingungen für die Bandlücke und die Transporteigenschaften erfüllt sein sollen. Dabei kann in vorteilhafter Weise innerhalb der jeweiligen i-Schicht der Wert der Bandlücke und der Transporteigenschaften konstant gehalten werden. Es ist dennoch vorstellbar, innerhal der jeweiligen i-Schicht eine begrenzte Variation des jeweiligen Wertes zuzulassen.

Desweiteren kann die Sammlung der Ladungsträger durch eine Änderung des elektrischen Feldes (z.B. durch Mikrodotierung der i-Schichten) beeinflußt werden, um auf diese Weise die räumliche Ladungsträgersammlung weiter zu variieren.

Es wurde zudem erkannt, daß dabei die Struktur nicht auf Strukturen des Types nipin oder pinip beschränkt ist; vielmehr und auch ausdrücklich von der Erfindung mitumfaßt sind auch überraschend einfache Strukturen und eine solche Struktur enthaltende Bauelemente des Typs einer einfachen pin- oder nip-Struktur. Vorteilhafterweise genügt bei einer solchen Struktur eine einzige Polarität im Gegensatz zu den vermeindlich für notwendig erachteten, antiseriellen geschalteten Doppeldioden des Types einer pinip- oder nipin-Struktur.

Durch Variation der an die erfindungsdgemäße pin-, nip-, pinip- oder nipin-Struktur angelegten Spannung kann bei dieser Struktur bzw. diesem Bauelement die spektrale Empfindlichkeit im Bereich vom fernen Ultravioletten (UV) bis hin zum nahen Infraroten (IR) verschoben und den erwünschten Randbedingungen entsprechend eingestellt werden.

In vorteilhafter Weise ist die erfindungsgemäße Struktur so beschaffen, daß sie die Detektion von Licht verschiedener Wellenlängen durch Variation der an die Struktur angelegten Spannung kontinuierlich einstellbar macht und damit im Ergebnis die erforderliche Superposition zumindest verringert.

Die Erfindung ist im weiteren an Hand von Figuren und Ausführungsbeispielen näher erläutert. Es zeigt:
- Fig. 1:: örtlicher Verlauf der Bandlücke E_{g} und des Produkts µτ einer zur Bildung beispielsweise eines Farbsensors geeigneten, erfindungsgemäßen nipin-Struktur;
- Fig. 2:: spektrale Empfindlichkeit einer nipin-Struktur nach Figur 1;
- Fig. 3:: Defektdichte N_{D} als Funktion des optischen Bandabstandes für a-Si₁₋ₓGeₓ:H, wobei in der Einfügung der optische Bandabstand als Funktion des Germaniumgehaltes im Material dargestellt ist;
- Fig. 4:: Photo- ((O) bzw. AM 1.5) und Dunkelleitfähigkeit (•) σ als Funktion des optischen Bandabstandes E_{g} für a-Si₁₋ₓGeₓ:H;
- Fig. 5:: ambipolare Diffusionslänge L_{ambi} als Funktion des optischen Bandabstandes E_{g} für a-Si₁₋ₓGeₓ:H im Vergleich zu aus der Literatur bekannten Werten [3, 4, 5] ;
- Fig. 6:: Photoleitfähigkeit σ als Funktion des optischen Bandabstandes E_{g} für a-Si₁₋ₓCₓ:H, hergestellt aus einem Silan/Methan-Gemisch, mit (o) und ohne (•) Wasserstoffverdünnung; Kreise nach [6], Quadrate nach [2];
- Fig. 7:: Einfluß der Mikrodotierung auf das elektrische Feld für eine nip-Struktur mit drei i-Schichtbereichen I, II und III, die ein unterschiedliches Transportverhalten (µτ^{I}, µτ^{II}, µτ^{III}) für Ladungsträger besitzen;
- Fig. 8:: Bandgapprofil und Variation der Transporteigenschaften eines Farbsensors auf der Basis einer pin-Struktur;
- Fig. 9:: Spannungsabhängige, spektrale Empfindlichkeit eines unipolaren Farbsensors auf der Basis einer pin-Struktur mit drei i-Schichtbereichen.

### Ausführungsbeispiele

In der Figur 1 ist eine Struktur des Typs nipin im Querschnitt gezeigt mit von der Lichteinfallsrichtung (von links nach rechts) nacheinander ausbildeter Top- und Bottomdiode. Dabei zeigt die obere Darstellung den Verlauf der Bandlücke E_{g}, die untere Darstellung den Verlauf der Transporteigenschaften µτ als Funktion der Ortskoordinate x in der Schichtenfolge.

Die Topdiode enthält eine nip-Struktur mit zwei i-Schichten i^{I} und i^{II}. Diese sind dabei so ausgebildet, daß sie eine Bandlücke Eg^{I} = 2,0 eV bzw. Eg^{II} = 1,95 eV aufweisen. Hergestellt wurden diese beiden Schichten mit Hilfe eines Silan-Methan-Gemisches im-Verhältnis 20 sccm / 20 sccm für i^{I} bzw. 4 sccm / (4 sccm mit 180 sccm H2) für i^{II}. Sowohl bei der Top- als auch der Bottomdiode wurden konstante Werte für E_{g} und µτ innerhalb der jeweiligen i-Schicht eingestellt.

Die hintere Bottomdiode enthält eine pin-Struktur mit drei i-Schichten i^{III}, i^{IV} und i^{V}. Diese sind dabei so ausgebildet, daß sie eine Bandlücke Eg^{III} = 1,9 eV bzw. Eg^{IV} = 1,65 eV bzw. Eg^{V} = 1,50 eV aufweisen. Gebildet wurden diese i-Schichten i^{III}, i^{IV} bzw. i^{V} aus amorphem Si (C) , a-Si₁₋ₓGeₓ (mit x=0, 5) bzw. a-Si₁₋ₓGeₓ (mit x=0,20).

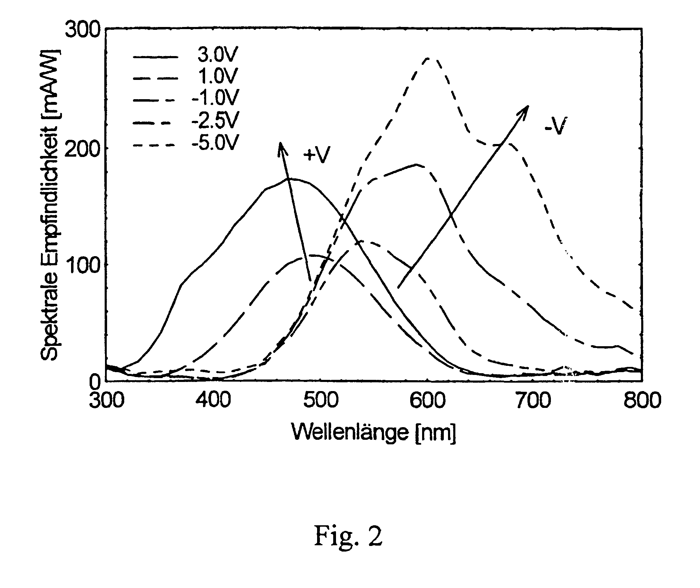

In der Figur 2 ist als Beispiel für einen 5-Farbensensor mit einer Struktur gemäß Figur 1 demonstriert, wie sich von positiver höherer Spannung (die vordere Diode ist in Sperrichtung) die spektrale Empfindlichkeit von einer Wellenlänge von 470 nm (Sammlung aller generierten Ladungsträger in der vorderen Topdiode) auf 500 nm für niedrige positive Spannungen verschiebbar einstellen läßt.

Durch unterschiedliche µτ-Produkte in den intrinsischen Schichten der Topdiode werden bei kleineren positiven Spannungen die photogenerierten Elektron-Loch-Paare im hinteren Teil der intrinsischen i-Schicht (Bereich µτ^{II}) eingesammelt, während die generierten Ladungsträgerpaare im Bereich des geringeren µτ-Produkts rekombinieren.

Die unterschiedlichen µτ-Produkte werden beispielsweisedurch die Verwendung von Materialien, hergestellt mit unterschiedlicher Wasserstoffverdünnung, realisiert. Erst bei höheren positiven Spannungen steigt das elektrische Feld über der Topdiode an und die Ladungsträgerpaare können im vorderen Bereich der intrinsischen i-Schicht der Topdiode eingesammelt werden.

Für negative Spannungen bzw. für die hintere Bottom-Diode wurden drei unterschiedliche Bereiche mit unterschiedlichem µτ-Produkt gewählt. Durch Anlegen negativer Spannungen ist die Bottomdiode in Sperrichtung, und die photogenerierten Ladungsträger können in dieser Diode eingesammelt werden. Für kleine negative Spannungen werden die Ladungsträgerpaare im Bereich (µτ)^{III} eingesammelt (Maximum der spektralen Empfindlichkeit bei 550 nm), während sie in allen anderen Bereichen ((µτ)^{IV} und (µτ)^{V}) durch den Einbau von Material mit geringerer Lebensdauer rekombinieren. Erhöht man das elektrische Feld über der intrinsische Schicht in der Bottomdiode, sammelt man die Ladungsträger in den Bereichen mit (µτ )^{III} und (µτ)^{IV} ein, während die photogenerierten Ladungsträger in Bereich mit (µτ)^{V} weiterhin rekombinieren (Maximum der spektralen Empfindlichkeit bei 595 nm).

Bei noch höher angelegter, negativer Spannung werden alle photogenerierten Ladungsträger in der Bottomdiode eingesammelt und es wird ein weiteres Maximum in der spektralen Empfindlichkeit bei 650 nm beobachtet. Somit können z.B. bei Spannungswerten von +3V, 1V, -1V, -2V und -4V jeweils linear unabhängige Verläufe der spektralen Empfindlichkeit detektiert werden.

Durch viele weitere i-Schichtenbereiche mit jeweils unterschiedlicher Transporteigenschaft (µτ-Produkt) kann auf diese Weise eine im wesentlichen kontinuierliche, spannungsabhängige spektrale Empfindlichkeit realisiert werden. Dabei kommt eine Struktur mit sehr vielen i-Schichten mit jeweils unterschiedlicher Bandlücke und Transporteigenschaften gleich einer Struktur mit einer i-Schicht mit innerhalb dieser variabeler Bandlücke und/oder Transporteigenschaft. Auch diese Ausführungsform wird als unter dem Gegenstand der aufgestellten Ansprüche f allend angesehen und als solche beansprucht.

Die Transporteigenschaften lassen sich beispielsweise durch eine oder mehrere folgender Maßnahmen einstellen bzw. verändern:
a) Einbau von Germanium (Ge), Kohlenstoff (C), Stickstoff (N) oder Sauerstoff (O) in das amorphe Siliziumnetzwerk, beispielsweise a-SiGe:H, a-SiC, a-SiH, a-Si₁₋ₓNₓ:H oder a-Si₁₋ₓOₓ:H ;
b) Zugabe von Wasserstoff bzw. Variation der Wasserstoffkonzentration bei den Prozeßgasen sowohl für a-Si:H als auch für dessen Legierungen, wie unter Punkt a) genannt;
c) Variation der Prozeßparameter, wie zum Beispiel Druck, Temperatur oder Leistung.

Die Herstellungsbedingungen können auf die Transporteigenschaften von a-Si:H basierenden Legierungen im einzelnen folgenden Einf luß haben:

Beim amorphen Silizium (a-Si:H) lassen sich die optoelektronischen Eigenschaften durch Variation der Herstellungsbedingungen beeinflussen. Beispielsweise kann die Materialqualität durch Variation des Depositionsdrucks, der Temperatur, der zugeführten elektrischen Leistung oder durch geeignete Beigabe von zusätzlichen Prozeßgasen (z. B. Wasserstoff, Helium, Argon, Fluor) bei der Schicht-Deposition verändert werden. Dies bedeutet, daß die Ladungsträger-Transporteigenschaften (d.h. das Produkt aus Ladungsträger-Lebensdauer und Ladungsträger-Beweglichkeit sowie die ambipolare Diffusionslänge) gezielt eingestellt werden können.

Bei den Legierungen des amorphen Siliziums, wie zum Beispiel den Silizium-Germanium- (a-Si₁₋ₓGeₓ:H) und den Silizium-Kohlenstoff-Legierungen (a-Si₁₋ₓCₓ:H) ändern sich die Transporteigenschaften zum Teil sehr stark, schon mit der Zusammensetzung der jeweiligen Legierung.

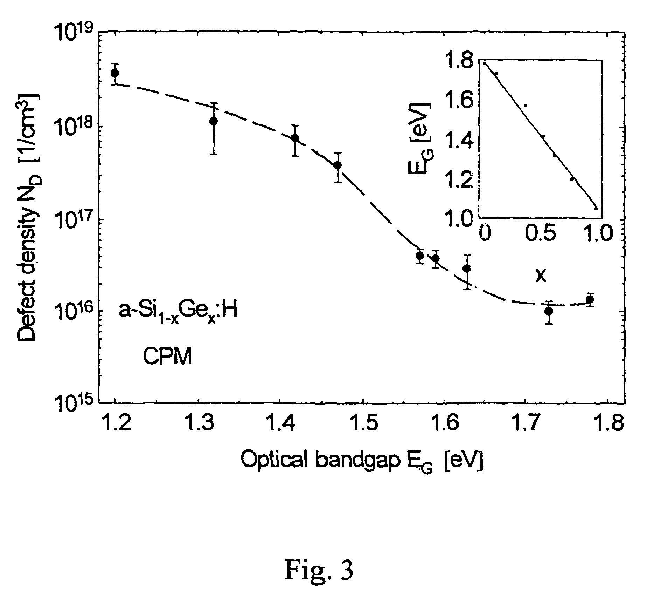

Dieses Verhalten ist am Beispiel der Silizium-Germanium-Legierung in den Figuren 3 bis 5 dargestellt.

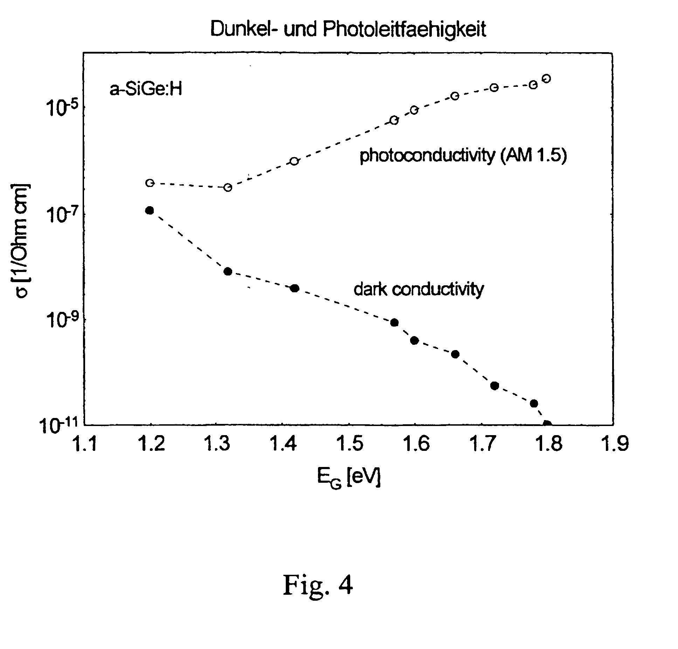

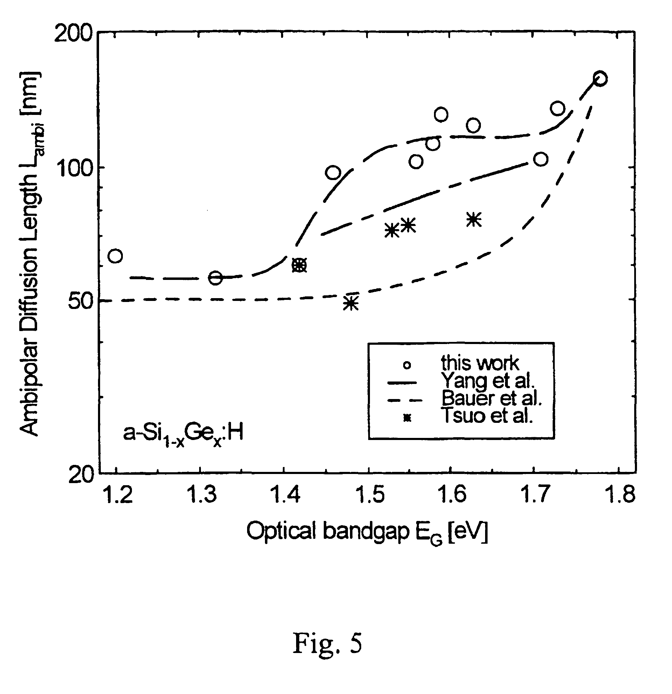

Mit zunehmendem Germaniumgehalt läßt sich der optische Bandabstand kontinuierlich zwischen E_{G} ≈ 1,8 eV (a-Si:H) und E_{G} ≈ 1,0 eV (a-Ge:H) einstellen, wie aus der Einfügung in Figur 3 entnehmbar. Mit zunehmendem Ge-Gehalt steigt die Defektdichte, ermittelt mit dem als "Constant Photocurrent Method" bezeichneten Meßverfahren, um zwei Größenordnungen oder mehr an (Figur 3, großes Bild). Gleichzeitig verändern sich die Photound die Dunkelleitfähigkeit (siehe Figur 4) sowie die ambipolare Diffusionslänge (siehe Figur 5) in Abhängigkeit von der Legierungszusammensetzung. Die Photoleitfähigkeit ist dabei proportional zum Produkt aus Ladungsträger-Lebensdauer τ und Beweglichkeit µ und spiegelt die Transporteigenschaften der Majoritätsladungsträger (hier: Elektronen) wieder. Die ambipolare Diffusionslänge beschreibt dabei für das hier vorliegende Material im wesentlichen die Transporteigenschaften der Minoritätsladungsträger (hier: Löcher).

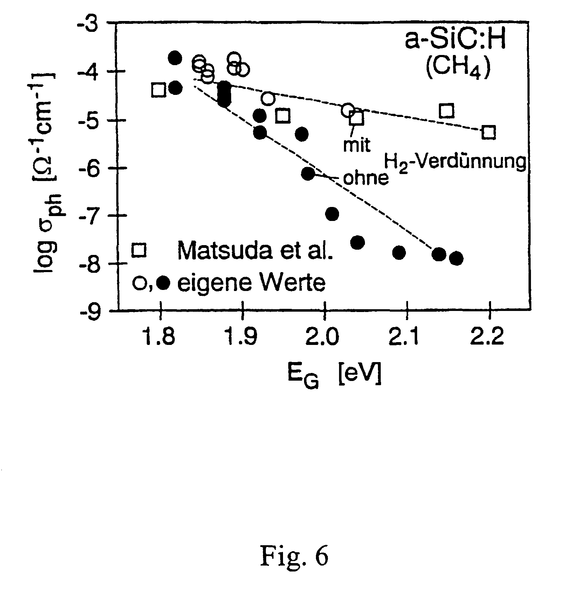

Darüber hinaus können (wie beim a-Si:H) bei den Siliziumlegierungen durch präparative Maßnahmen (wie oben beschrieben), insbesondere durch die Zugabe zusätzlicher Prozeßgase während der Deposition, die Transporteigenschaften beeinflußt werden [Matsuda 1,2]. Als Beispiel ist in der Figur 6 für das Legierungssystem a-Si₁₋ₓCₓ:H der Einfluß von Wasserstoffzugabe ("Wasserstoff-verdünnung") zu den Prozeßgasen Silan (SiH₄) und Methan (CH₄) dargestellt. Mit starker Wasserstoffverdünnung hergestelltes Material zeigt eine wesentlich größere Photoleitfähigkeit und damit höhere Werte für das µτ-Produkt als in den Fällen, wo deponiertes Material ohne H₂-Zugabe verwendet wird. Dabei nimmt dieser Effekt mit zunehmendem C (Kohlenstoff)-Gehalt im Material stark zu. Das Verhältnis von [H₂] zu ([SiH₄]+[CH₄]) kann dabei zum Beispiel Werte annehmen von 10 bis 50.

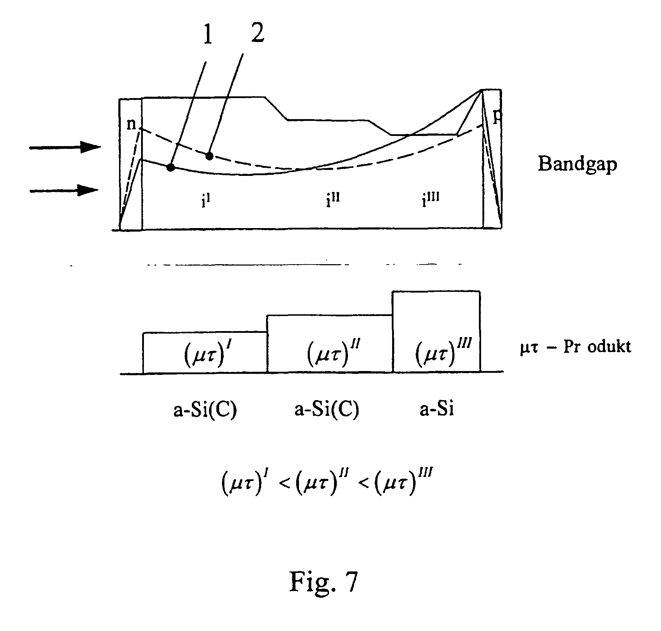

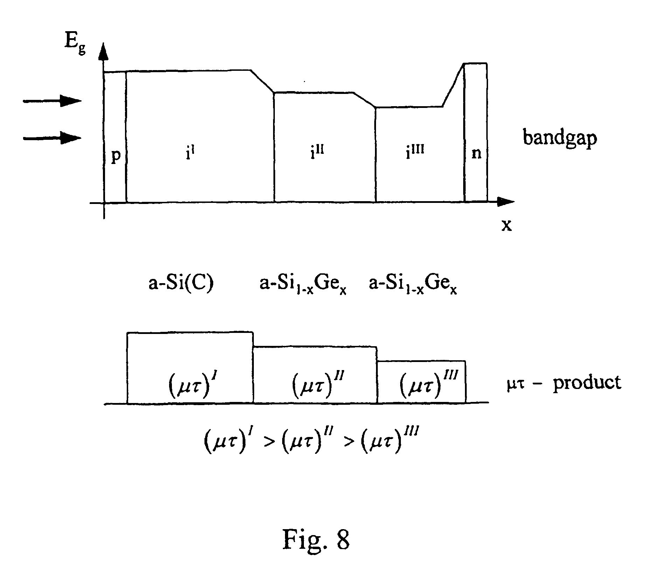

Aus der Literatur und aus Veröffentlichungen über pin-Solarzellen ist bekannt, daß sich die Sammlung von blauem Licht in pin-Dioden durch eine Dotiergasverschleppung (wie zum Beispiel Bor) im vorderen Bereich reduzieren und beispielsweise durch eine Phosphordotierung in der i-Schicht erhöhen läßt. Durch die Kombination der Mikrodotierung bei gleichzeitiger Variation des Bandgaps E_{g} und der Transporteigenschaften in den einzelnen i-Schichten läßt sich die spektrale Farbtrennung weiter verbessern. Dies wird erläutert an Hand der Topdiode (nip-Struktur) einer nipin-Struktur (Figur 7, Figur 8).

Figur 7 zeigt den Verlauf der Bandlücke Eg und der Transporteigenschaften µτ als Funktion der Koordinate einer erfindungsgemäßen nip-Struktur mit-drei i-Schichten. Durch den Einbau von Phosphor (Figur 7, Kurve 1) wird positive, ortfeste Ladung in die Absorberschicht eingebaut. Somit wird das elektrische Feld im Bereich des p/i-Übergangs erhöht, während es im in anderen Teil der Absorberschicht (im Bereich des i/n-Übergangs) reduziert wird. Somit wird die ortsabhängige Sammlung durch den ortabhängigen Feldverlauf unterstützt. Der entgegengesetzte Einfluß wird für den Einbau von Bor beobachtet (Figur 7, Kurve 2).

Entsprechende Optimierung der Farbtrennung beispielsweise durch den Einbau von Phosphor kann selbstverständlich auch in der Bottomdiode einer nipin- bzw. in den intrinsischen i-Schichten einer pinip-Struktur vorgenommen werden.

Desweiteren kann auch mit Hilfe einer teilweise Dotierung einzelner i-Schichten der modifizierten Absorberschicht (mit zum Beispiel Bor, Phosphor, Arsen oder Fluor) das Feld und somit die wellenlängenabhängige Sammeleffizienz verändert bzw. eingestellt werden.

Zum Mehrfarbensensor auf der Basis einer nip- oder pin-Struktur, wie zum Beispiel aus Figur 7 oder Figur 8 entnehmbar, wird noch folgendes ausgeführt :

Die erfindungsgemäße, als Photodiode geeignete nip- oder pin-Struktur, deren spektrale Empfindlichkeit durch Variation der angelegten Spannung verschiebbar ist, ermöglicht die Bildung eines unipolaren Detektors, bei dem nur eine einzige Polarität der an die Struktur angelegten Spannung benötigt wird, um die drei bekannten (Rot, Grün und Blau), andere Farben oder sogar mehrere dieser Farben zu detektieren.

Da mit der erfindungsgemäßen Struktur in beispielsweise einer Bottomdiode wegen drei linear unabhängiger Gleichungen drei oder mehrere Farben in der oben angegebenen Weise detektiert werden können, reicht bereits eine Struktur auf der Basis einer pin- oder nip-Schichtenfolge mit jeweils drei benachbarten i-Schichten. Insofern übersteigt sie damit durch Lösung der gestellten Aufgabe entscheidend die Eigenschaften der als bekannt beschriebenen, im Aufbau weitaus aufwendiger gestalteten, antiseriellen pinip- bzw. nipin- Schichtenfolge erheblich. Erfindungsgemäß realisiert wird auch ein u-nipolarer drei- oder mehr-Farbensensor auf der Grundlage einer pin-oder nip-Struktur, insbesondere auf der Basis des amorphen Siliziums oder dessen Legierungen.

Eine solche für die Bildung eines Sensor geeignete Struktur weist auch den Vorteil auf, daß bei Ausbildung eines Sensorarrays mit Hilfe einer solchen Struktur eine deutlich reduzierte Kopplung benachbarter Pixel auftritt, da diese Struktur im Vergleich zu einer nipin- oder pinip-Struktur keine leitfähige Mittelschicht in Form der beidseitig von i-Schichten benachbarten p- bzw. n-Schicht besitzt. Außerdem wird für die angelegte Spannung in vorteilhafter Weise nur noch eine einzige Polarität benötigt.

Außerdem ist bei der erfindungsgemäßen Struktur das transiente Verhalten gegenüber einem Detektor auf der Basis zweier antiserieller Dioden verbessert, weil Ladungsvorgänge der gespeicherten Ladung in der Top- oder Bottom-Diode nicht auftreten, wie man sie bei pinip- oder nipin-Strukturen beobachtet.

Vorstellbar und auch erwünscht kann dabei die Verwendung von drei oder mehreren i-Schichtbereichen mit jeweils unterschiedlichem µτ-Produkt sein. Zur Optimierung kann analog der nipin-Struktur eine Mikrodotierung erfolgen. Als eine solche Dotierung kann dazu Phosphor, Bor oder Arsen Einsatz finden.

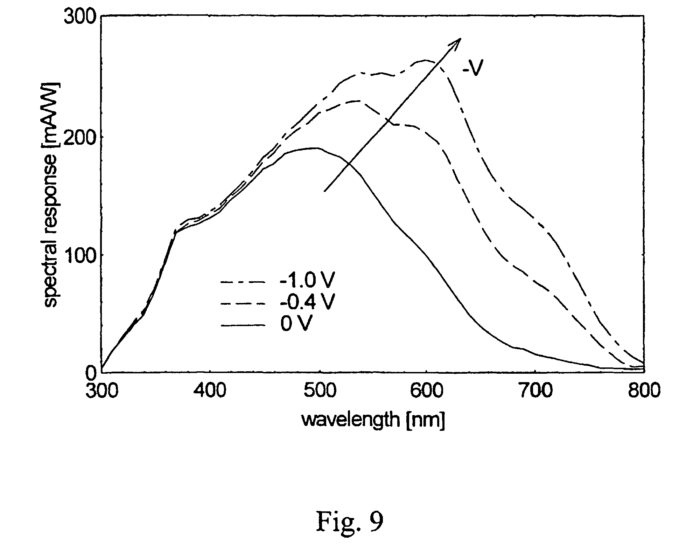

Bei einer pin-Struktur wird das Bandgap E_{g} in Lichteinfallsrichtung an den Grenzbereichen zweier benachbarten i-Schichten reduziert. Die Absorberschicht wird in drei Bereiche mit unterschiedlichem µτ-Produkt eingeteilt, wobei sich die Transporteigenschaften der verwendeten Materialien ebenfalls von der p-leitenden Schicht zur n-leitende Schicht verschlechtern, wie in Figur 8 dargestellt. In der Figur 9 sind Meßergebnisse zu einer Struktur gemäß Figur 8 gezeigt, die für ansteigender negativ angelegter Spannung die Verschiebung der spektralen Empfindlichkeit und deren gezeilte Einstelbarkeit als Funktion der Wellenlänge des Lichtes aufzeigen.

Bei einer nip-Struktur wird die Bandlücke von der Lichteinfallsrichtung (n-Schicht) aus ebenfalls reduziert, während die Transporteigenschaften in den drei unterschiedlichen Bereichen von der n-Schicht zur p-Schicht besser werden.

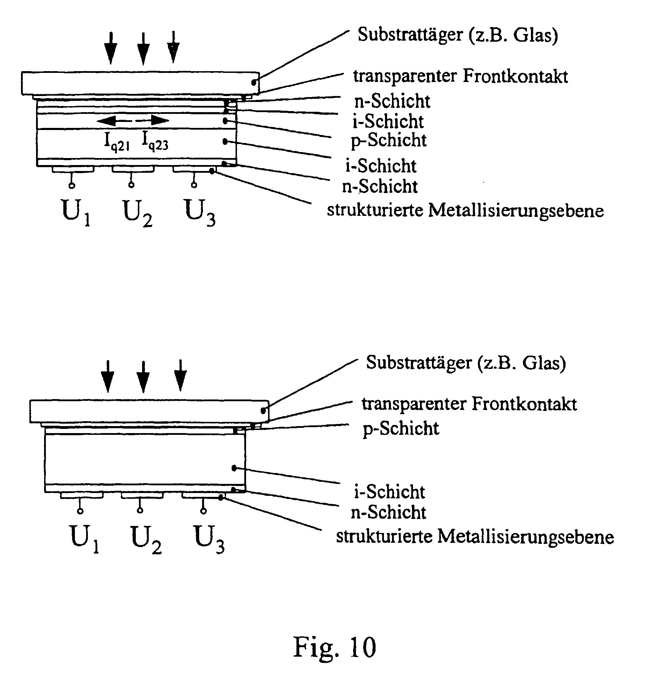

Zu der Figur 10, in der schematisch eine Sensorzeile oder ein Sensorarray des Typs nipin- oder pin-Farbsensors dargestellt ist, wird noch ausgeführt:

Die hohe Leitfähigkeit dotierter n- und p-Schichten führt in unstrukurierten Sensorarrays oder Sensorzeilen zu Koppelströmen senkrecht zur Lichteinfallsrichtung. Die Fläche eines aktiven Pixels in einem unstrukturierten Sensorarray wird durch seinen Rückkontakt (strukturierte Metallisierungsebene) definiert. Ein auftretender Koppelstrom (I_{q}) überlagert den Photostrom und erschwert bzw. verhindert die Auswertung des Signals. Koppelprozesse über die n-Schicht (letzte Halbleiterschicht vor dem Rückkontakt) bei einer nipin- oder pin-Diode (bei einem pinip-Detektor entsprechend die p-Schicht) können durch technologische Maßnahmen (z.B. invertierte Deposition auf einem strukturierten Substrat, bei dem die n-Schicht an zuvor definierten Pixelkanten abreißt) oder durch die Beschaltung (U₁ = U₂ = U₃ ....) verhindert werden. Die Kopplung über die p-Schicht bei einem nipin-Detektor (entsprechend Kopplung über die n-Schicht bei einer pinip-Diode) läßt sich nur durch eine vollständige Strukturierung (Entfernung des Dünnschichtsystems zwischen einzelnen Pixeln) des Arrays oder durch den Übergang zu einem unipolaren Detektor (pin- oder nip-Diode), bei dem das komplexe i-Schichtsystem im Bauelement nicht durch eine Schicht mit hoher Leitfähigkeit unterbrochen wird, verhindern. Da die Strukturierung des vollständigen Arrays technologisch aufwendig und kostenintensiv ist, bildet ein unstrukturiertes Sensorarray aus pin- oder nip-Dioden, die drei oder mehr Spektralanteile des Lichts trennen können, einen Fortschritt im Hinblick auf die Reduktion des Koppelstroms.

## Patentansprüche

1. Struktur mit benachbarten i-Schichten (i^{I}, i^{II}), die an einer Seite von einer p-Schicht, an der anderen Seite von einer n-Schicht begrenzt wird, wobei die i-Schichten im wesentlichen vertikal zur Lichteinfallsrichtung angeordnet sind und die Bandlücken Eg(i) der i-Schichten in Lichteinfallsrichtung abnehmen,
**dadurch gekennzeichnet,**
**daß** wenigstens drei benachbarte i-Schichten vorliegen, und das Produkt aus Ladungsträgerbeweglichkeit und Lebensdauer µτ(i), der einzelnen i-Schichten in Richtung von der p-Schicht zur n-Schicht abnimmt.

2. Struktur nach Anspruch 1,
**gekennzeichnet durch**
eine pin- oder eine nip-Struktur.

3. Struktur nach einem der Ansprüche 1 oder 2 mit einer Mehrzahl von i-Schichten oder einer Vielzahl von i-Schichten (I, II, ...).

4. Struktur nach einem der Ansprüche 1, 2 oder 3, wobei in einer oder mehrerer i-Schichten, insbesondere in allen i-Schichten (I, II, ...), die jeweilige Bandlücke E_{G}(I, II, ....) innerhalb dieser i-Schicht einen konstanten Wert aufweist.

5. Struktur nach einem der Ansprüche 1, 2, 3 oder 4, wobei in einer oder mehrerer i-Schichten, insbesondere in allen i-Schichten (I, II, ...), das jeweilige Produkt µτ (I, II, ....) innerhalb dieser i-Schicht einen konstanten Wert aufweist.

6. Struktur nach einem der Ansprüche 1, 2, 3, 4 oder 5, wobei zur Bildung einer pinip-Struktur die n-Schicht an der von der i-Schicht benachbarten Seite eine weitere Schichtenfolge mit einer oder mehreren i-Schichten sowie eine diese weitere Schichtenfolge begrenzende, weitere p-Schicht aufweist.

7. Struktur nach einem der Ansprüche 1, 2, 3, 4 oder 5, wobei zur Bildung einer nipin-Struktur die p-Schicht an der von der i-Schicht benachbarten Seite eine weitere Schichtenfolge mit einer oder mehreren i-Schichten sowie eine diese weitere Schichtenfolge begrenzende, weitere n-Schicht aufweist.

8. Struktur nach Anspruch 6 oder 7,
**gekennzeichnet durch**
Mittel zur Ausbildung der weiteren Schichtenfolge, die bewirken, daß
- in Lichteinfallsrichtung wenigstens im Grenzbereich zweier benachbarter i-Schichten (i^{I}, i^{II}) dieser weiteren Schichtenfolge die Bandlücke Eg(I) der jeweiligen der Lichteintrittsseite näher benachbarten, ersteren i-Schicht (i^{I}) größer ist als die Bandlücke E_{g}(II) der mit ihr benachbarten, der Lichteintrittsseite weiter entfernten, zweiten i-Schicht (i^{II}),
- in Richtung von der p- zur n-Schicht wenigstens im Grenzbereich zweier benachbarter i-Schichten (i^{I}, i^{II}) dieser weiteren Schichtenfolge das Produkt µτ(I) der von der n-Schicht weiter entfernten i-Schicht (i^{I}) größer ist als das Produkt µτ(II) der der n-Schicht näher benachbarten i-Schicht (i^{II}).

9. Array mit einer Vielzahl jeweils einen Pixel bildende Strukturen nach einem der Ansprüche 1 bis 8.

10. Eine Struktur oder mehrere Strukturen nach einem oder mehreren der Ansprüche 1 bis 9 enthaltendes elektronisches Bauelement, insbesondere ein Mehrfarbensensor.

11. Verfahren zur Herstellung einer Struktur nach einem der Ansprüche 1 bis 9,
**dadurch gekennzeichnet, daß**
- eine Struktur mit mehreren i-Schichten gebildet wird, die an einer Seite von einer p-Schicht an der anderen Seite von einer n-Schicht begrenzt werden und dabei Mittel zur Ausbildung dieser i-Schichten gewählt werden, die bewirken, daß
- in Lichteinfallsrichtung wenigstens im Grenzbereich zweier benachbarter i-Schichten die Bandlücke E_{g}(I) der jeweiligen der Lichteintrittsseite näher benachbarten, ersteren i-Schicht größer ist als die Bandlücke E_{g}(II) der mit ihr benachbarten, der Lichteintrittsseite weiter entfernten, zweiten i-Schicht,
- in Richtung von der p- zur n-Schicht wenigstens im Grenzbereich zweier benachbarter i-Schichten (i^{I}, i^{II}) das Produkt µτ(I) der von der n-Schicht weiter entfernten i-Schicht (i^{I}) größer ist als das Produkt µτ(II) der der n-Schicht näher benachbarten i-Schicht (i^{II}).

## Claims

1. A structure comprising adjacent i-layers (i^{I}, i^{II}) which are bounded on one side by a p-layer and are bounded on the other side by an n-layer, wherein the i-layers are disposed substantially vertically to the direction of light incidence and the band gaps E_{g}(i) of the i-layers decrease in the direction of light incidence,
**characterised in that**
at least three adjacent i-layers are present and the product of the charge carrier mobility and the lifetime µτ(i) of the individual i-layers decreases in the direction from the p-layer to the n-layer.

2. A structure according to claim 1,
**characterised by**
a pin or a nip structure.

3. A structure according to either one of claims 1 or 2, comprising a majority of i-layers or a multiplicity of i-layers (I, II, ...).

4. A structure according to any one of claims 1, 2 or 3, wherein in one or more i-layers, particularly in all the i-layers (I, II, ...)., the respective band gap E_{g}(I, II, ...) has a constant value within said i-layer.

5. A structure according to any one of claims 1, 2, 3 or 4, wherein in one or more i-layers, particularly in all the i-layers (I, II, ...)., the respective product µτ (I, II, ...) has a constant value within said i-layer.

6. A structure according to any one of claims 1, 2, 3, 4 or 5, wherein in order to form a pinip structure the n-layer has a further layer sequence comprising one or more i-layers on its side adjacent to the i-layer, as well as a further p-layer which delimits said further layer sequence.

7. A structure according to any one of claims 1, 2, 3, 4 or 5, wherein in order to form a nipin structure the p-layer has a further layer sequence comprising one or more i-layers on its side adjacent to the i-layer, as well as a further n-layer which delimits said further layer sequence.

8. A structure according to claim 6 or 7,
**characterised by**
means for forming the further layer sequence, the effect of which is that
- in the direction of light incidence, at least in the boundary region of two adjacent i-layers (i^{I}, i^{II}) of said further layer sequence, the band gap E_{g}(I) of the respective first i-layer (i^{I}) which is more closely adjacent to the light entry side is larger than the band gap E_{g}(II) of the second i-layer (i^{II}) which is adjacent to the first layer but which is further from the light entry side,
- in the direction from the p- to the n-layer, at least in the boundary region of two adjacent i-layers (i^{I}, i^{II}) of said further layer sequence, the product µτ (I) of the i-layer (i^{I}) which is further from the n-layer is greater than the product µτ (II) of the i-layer (i^{II}) which is more closely adjacent to the n-layer.

9. An array comprising a multiplicity of structures according to any one of claims I to 8, each of which forms a pixel.

10. An electronic component, particularly a multi-colour sensor, containing a structure or a plurality of structures according to one or more of claims 1 to 9.

11. A method of producing a structure according to any one of claims 1 to 9,
**characterised in that**
- a structure is formed which comprises a plurality of i-layers which are bounded on one side by a p-layer and on the other side by an n-layer, and moreover means are selected for forming said i-layers, the effect of which is that
- in the direction of light incidence, at least in the boundary region of two adjacent i-layers, the band gap Eg(I) of the respective first i-layer which is more closely adjacent to the light entry side is larger than the band gap E_{g}(II) of the second i-layer which is adjacent to the first layer but which is further from the light entry side,
- in the direction from the p- to the n-layer, at least in the boundary region of two adjacent i-layers (i^{I}, i^{II}), the product µτ (I) of the i-layer (i^{I}) which is further from the n-layer is greater than the product µτ(II) of the i-layer (i^{II}) which is more closely adjacent to the n-layer.

## Revendications

1. Structure comprenant des couches (i^{I}, i^{II}) i voisines, qui est délimitée sur une face par une couche p et sur l'autre face par une couche n, les couches i étant disposées sensiblement verticalement par rapport à la direction d'incidence de la lumière et les écarts énergétiques Eg (i) des couches i diminuant dans la direction d'incidence de la lumière,
**caractérisée,**
**en ce qu'**il y a au moins trois couches i voisines et le produit de la mobilité des porteurs de charge par la durée de vie µτ(i) des diverses couches i diminuant en allant de la couche p à la couche n.

2. Structure suivant la revendication 1,
**caractérisée par**
une structure pin ou une structure nip.

3. Structure suivant l'une des revendications 1 ou 2, comprenant une multiplicité de couches i ou une pluralité de couches i (I, II...)

4. Structure suivant l'une des revendications 1, 2 ou 3, dans laquelle dans une couche i ou dans plusieurs couches i, notamment dans toutes les couches i (I, II...), les écarts énergétiques Eg (I, II ...) respectives ont une valeur constante au sein de cette couche i.

5. Structure suivant l'une des revendications 1, 2, 3 ou 4 dans laquelle dans une couche i ou dans plusieurs couches i, notamment dans toutes les couches i (I, II...), le produit µτ (I, II...) respectif à une valeur constante au sein de cette couche i

6. Structure suivant l'une des revendications 1, 2, 3, 4 ou 5, dans laquelle pour la formation d'une structure pinip, la couche n a sur la face voisine de la couche i une autre succession de couches ayant une couche i ou plusieurs couches i, ainsi qu'une autre couche p limitant cette autre succession de couches.

7. Structure suivant l'une des revendications 1, 2,3, 4 ou 5, dans laquelle pour la formation d'une couche nipin, la couche p a sur la face voisine de la couche i une autre succession de couches ayant une couche i ou plusieurs couches i, ainsi qu'une autre couche n limitant cette autre succession de couches.

8. Structure suivant la revendication 6 ou 7, **caractérisée par** des moyens de constitution de l'autre succession de couches qui font que :
- dans la direction d'incidence de la lumière au moins dans la zone limite entre deux couches i (i^{I}, i^{II}) voisines de cette autre succession de couches, l'écart énergétique Eg (I) de la première couche i (i^{I}) voisine proche de la face d'entrée de la lumière est plus grand que l'écart énergétique Eg (II) de la deuxième couche i (i^{II}) qui en est voisine et qui est plus éloignée de la face d'entrée de la lumière.
- dans la direction allant de la couche p à la couche n , au moins dans la zone limite entre deux couches i (i^{I}, i ^{II} ) voisines de cette autre succession de couches, le produit µτ (I) de la couche i (i^{I}) plus éloignée de la couche n est plus grand que le produit µτ (II) de la couche i (i^{II}) voisine proche de la couche n.

9. Réseau ayant une pluralité de structures formant respectivement un pixel suivant l'une des revendications 1 à 8.

10. Composant électronique, notamment capteur multicolore, comportant une structure ou plusieurs structures suivant l'une ou plusieurs des revendications 1 à 9.

11. Procédé de production d'une structure suivant l'une des revendications 1 à 9, **caractérisé en ce que**:
- on forme une structure ayant plusieurs couches i qui sont délimitées sur une face par une couche p et sur l'autre face par une couche n et on choisit à cet effet des moyens de constitution de ces couches i qui font que
- dans la direction d'incidence de la lumière au moins dans la zone limite entre deux couches i (i^{I}, i^{II}) voisines de cette autre succession de couches, l'écart énergétique Eg (I) de la première couche i (i^{I}) voisine proche de la face d'entrée de la lumière est plus grand que l'écart énergétique Eg (II) de la deuxième couche i (i^{II}) qui en est voisine et qui est plus éloignée de la face d'entrée de la lumière.
- dans la direction allant de la couche p à la couche n , au moins dans la zone limite entre deux couches i (i^{I}, i ^{II} ) voisines de cette autre succession de couches, le produit µτ (I) de la couche i (i^{I}) plus éloignée de la couche n est plus grand que le produit µτ (II) de la couche i (i^{II}) voisine proche de la couche n.
